# EUROPEAN PATENT SPECIFICATION

(11) **EP 2 878 862 B1**
(45) Date of publication and mention of the grant of the patent: **21.09.2016**
(21) Application number: 13823402.6
(22) Date of filing: 18.07.2013
(51) Int. Cl.: F16J 15/16, C08J 7/00, C08K 3/00, C08L 27/18

(54) **FLUORINE-RESIN SEALING RING**
FLUORHARZDICHTUNGSRING
BAGUE D'ÉTANCHÉITÉ EN RÉSINE FLUORÉE

(30) Priority: 25.07.2012 JP 2012164596
(43) Date of publication of application: 03.06.2015
(73) Proprietor: NOK Corporation, Minato-ku Tokyo 105-8585 (JP)
(72) Inventor: FUKASAWA Kiyofumi, Fujisawa-shi Kanagawa 251-0042 (JP); KOGA Akiko, Fujisawa-shi Kanagawa 251-0042 (JP); SUZUKI Akihiro, Fujisawa-shi Kanagawa 251-0042 (JP); KURIYAMA Hideki, Fujisawa-shi Kanagawa 251-0042 (JP)
(74) Representative: Beckmann, Claus
(86) International application number: PCT/JP2013/069504
(87) International publication number: WO 2014/017376

(56) References cited:
- JP-A- 2003 035 367
- JP-A- 2007 032 359
- JP-A- 2009 156 440
- US-A- 5 985 451
- US-A1- 2004 258 547

## Description

### TECHNICAL FIELD

The present invention relates to a fluororesin seal ring. More particularly, the present invention relates to a fluororesin seal ring that can prevent welding between fluororesin members.

### BACKGROUND ART

Resin seal rings are currently used in rotation or reciprocation, including hydraulic circuits such as automatic transmissions (A/T) and continuously variable transmissions (CVT) for vehicles. Such a resin seal ring generally comprises an abutting part, which is as a discontinuous part, in a part of the ring so as to ensure mountability to an annular groove, sealing properties under pressure, and slidability under ordinary pressure. The seal ring is designed so that when the seal ring is mounted, a slight circumstantial gap (abutting gap) is formed in the abutting part. As the temperature of the sealed fluid increases, the seal ring is thermally expanded, and the gap in the abutting part gradually narrows, leading to a state in which the cut surfaces of the abutting part are butted together. For example, a seal ring having a straight cut shape prevents the sealed fluid from leaking when the abutting gap is zero, thus exhibiting excellent sealing properties.

However, when the temperature of the sealed fluid further increases, and the seal ring is further expanded, compressive stress acts on the abutting portion. In such a state in which constant load is applied at a high temperature, compression set occurs at a stress lower than the stress in which plastic yield occurs. The abutting part is deformed (crept) as time passes, and finally stuck. It is known that this phenomenon not only depends on the temperature of the sealed fluid, but also is more likely to occur due to frictional heat generated when the abutting surfaces grind against each other because of vibration of a hydraulic system under pressurized conditions, and the like. If the abutting part is crept and stuck in that state, the crept or stuck part does not return to the original shape even after the temperature of the sealed fluid decreases. This has an adverse influence on the mounting state of the seal ring, causing a reduction in sealing properties during low-temperature operation.

In order to cope with the above problems, the present applicant proposes a seal ring material obtained by adding oil coke and carbon fiber to a fluororesin (Patent Document 1). The seal ring produced from this material has improved creep resistance; however, the fluororesins may stick together under conditions in which frictional heat is generated under pressure. In order to prevent sticking between the fluororesins, the fluororesin surface may be treated with a liquid coating agent. However, liquid coating agents generally have poor adhesion to fluororesins, and the coating film itself is highly likely to be welded and melted due to frictional heat.

### PRIOR ART DOCUMENT

### PATENT DOCUMENT

- Patent Document 1 :: JP-A-2003-035367
- Patent Document 2 :: JP-A-2010-203546
- Patent Document 3 :: JP-A-2010-249219
- Patent Document 4 :: JP-A-2003-182615
- Patent Document 5 :: WO 2007/043622
- Patent Document 6 :: JP-A-2006-176544
- Patent Document 7 :: JP-A-2005-232196
- Patent Document 8 :: JP-A-2002-317089
- Patent Document 9 :: JP-A-2001-294720
- Patent Document 10 :: JP-A-2007-154170
- Patent Document 11 :: JP-A-2000-9228
- Patent Document 12 :: JP-A-2002-161181
- Patent Document 13 :: JP-A-10-45989
- Patent Document 14 :: JP-A-62-109844
- Patent Document 15:: JP-A-2-32146
- Patent Document 16 :: JP-A-2000-1589

### OUTLINE OF THE INVENTION

### PROBLEM TO BE SOLVED BY THE INVENTION

An object of the present invention is to provide a PTFE resin seal ring in which the surfaces of its abutting part that forms a discontinuous part of the seal ring do not become sticky even after constant load is applied at a high temperature.

### MEANS FOR SOLVING THE PROBLEM

The above object of the present invention can be achieved by a PTFE resin seal ring in which an amorphous carbon film is formed on at least one surface of an abutting part that forms a discontinuous part of the seal ring.

### EFFECT OF THE INVENTION

Since an amorphous carbon film is formed on the abutting surfaces of the PTFE resin seal ring of the present invention, sticking does not occur in the abutting part even after constant load is applied at a high temperature. Thus, the PTFE resin seal ring of the present invention exhibits excellent effects of ensuring sealing properties under pressure and slidability under ordinary pressure, and is effectively used as sealing material in, for example, rotation or reciprocation, including hydraulic circuits such as automatic transmissions (A/T) and continuously variable transmissions (CVT) for vehicles.

### EMBODIMENTS FOR CARRYING OUT THE INVENTION

A preferably used seal ring is a PTFE resin seal ring that can be continuously used in a wide temperature range of -200 to +260°C, has excellent heat resistance and cold resistance, has a friction coefficient as very low as 0.04 to 0.3, and has excellent abrasion resistance. Usable examples of PTFE include not only homo-PTFE, but also PTFE partially (several mol% or less) modified with a monomer containing a polyfluoroalkyl group, such as fluoroalkyl vinyl ether and hexafluoropropylene, or ethylene, etc.

It is known that PTFE containing various fillers can be used for various applications. In the present invention, a filler can be used generally in an amount of about 70 wt.% or less, preferably about 1 to 30 wt.%, in the total amount of PTFE and the filler, although it varies depending on the type and properties of the filler. For example, the following fillers can be contained in PTFE. These fillers can be used in combination of two or more.

### Glass fiber: see Patent Documents 4 and 5.

Generally, glass fiber having an average fiber diameter of about 1 to 50 µm, preferably about 5 to 15 µm, and an average fiber length of about 10 to 1,000 µm, preferably about 50 to 200 µm, is used. It is preferable that the surface of such glass fiber is previously treated with a silane coupling agent, etc., and then used.

### Carbon fiber: see Patent Documents 1 and 5 to 9.

Usable examples include pitch-based carbon fiber, rayon-based carbon fiber, polyacrylonitrile-based carbon fiber, and the like, preferably pitch-based carbon fiber, particularly preferably highly graphitized pitch-based carbon fiber, generally having an average fiber diameter of about 1 to 50 µm, preferably about 5 to 20 µm, particularly preferably about 7 to 15 µm, and an average fiber length of about 10 to 1,000 µm, preferably about 20 to 500 µm, particularly preferably about 50 to 200 µm.

### Ceramic fiber or ceramic powder: see Patent Document 10.

Usable examples include fiber or powder of SiC, Al₂O₃, WC, Y₂O₃, MgO, SiO₂, Si₃N₄, ZrO₂, or the like, generally having an average particle diameter of about 0.4 to 100 µm, preferably about 0.7 to 30 µm.

### Graphite powder: see Patent Documents 9, 11, and 15.

Both natural graphite (earthy, massive, powdery, or other form of graphite) and artificial graphite can be used. The average particle diameter thereof is generally 30 µm or less, although it depends on their properties.

### Coke: see Patent Documents 1, 7, 8, and 14.

Usable examples include coal coke, petroleum coke, and the like, having an average particle diameter of about 1 to 200 µm, preferably 10 to 50 µm, particularly preferably about 3 to 30 µm.

### Carbon beads: see Patent Documents 8, 12, and 13.

Preferably, carbon beads obtained by using an aromatic polymer as a starting material, generally having an average particle diameter of about 3 to 30 µm, preferably about 10 to 20 µm, are used.

### Carbon black:

Ketchen black, thermal grade carbon black, and the like, having an arithmetic average particle diameter of about 70 to 90 nm are used.

### Bronze powder: see Patent Documents 15 and 16.

A Cu alloy containing 2 to 35 wt.% of Sn, for example, an alloy having a composition of Cu: 85 to 98 wt.%, preferably 88 to 92 wt.%, and Sn: 2 to 15 wt.%, preferably 8 to 12 wt.%, or an alloy having a Cu/Cr ratio of approximately 9:1, generally having an average particle diameter of about 10 to 50 µm, is used.

An amorphous carbon film is formed on at least one surface of the abutting part of the seal ring using a low-pressure plasma device by a plasma CVD method (plasma CVD treatment). Specifically, this treatment is performed by placing the seal ring in a vacuum chamber in a state where the abutting surfaces of the seal ring are not joined together, evacuating the chamber (vacuum chamber) to a predetermined degree of vacuum, generally 5 to 100 Pa or below by a vacuum pump, then introducing hydrocarbon gas, and applying predetermined electric power for a certain period of time using a high-frequency power supply at a predetermined frequency. The abutting part of the seal ring as mentioned herein is a discontinuous part provided in a part of the ring. The surfaces indicate the opposing surfaces in the abutting part, and examples of the shape include straight cut, stair-like step cut, special step cut, oblique bias cut, and the like. For example, an example of the straight cut shape is disclosed in Patent Document 1, and examples of the special step cut shape are disclosed in Patent Documents 2 and 3.

Examples of hydrocarbon gas used in the formation of an amorphous carbon film include methane, ethylene, propylene, acetylene, and the like. The embodiments of forming an amorphous carbon film include not only the basic embodiment in which only plasma CVD treatment with hydrocarbon gas is performed, but also the following embodiments:
(1) an embodiment in which plasma modification and plasma CVD treatment are simultaneously performed using hydrocarbon gas in combination with non-polymerizable gas at a volume ratio of hydrocarbon gas to non-polymerizable gas of 1:10 or less;
(2) an embodiment in which plasma modification is performed using non-polymerizable gas prior to the formation of an amorphous carbon film; and
(3) an embodiment in which after plasma modification is performed using non-polymerizable gas, plasma CVD treatment is performed using a gas mixture of hydrocarbon gas and non-polymerizable gas.
Examples of non-polymerizable gas include non-reactive gas, such as argon, helium, and nitrogen; reactive gas, such as oxygen; and the like.

An example of the low-pressure plasma device is one in which a lower electrode and an upper electrode are disposed in a vacuum chamber so as to face each other, and at least one of the electrodes is connected to a high-frequency power supply or a microwave power supply.

Plasma irradiation in the process of the formation of an amorphous carbon film is performed, for example, by reducing the pressure in the system to 5 to 100 Pa or below by a vacuum pump, introducing hydrocarbon gas so that the pressure in the vacuum chamber is 6 to 500 Pa, preferably 10 to 100 Pa, and supplying electric power of about 10 to 30,000 W for 1 to 60 minutes using a high-frequency power supply with a frequency of 40 kHz or 13.56 MHz, or a microwave power supply with a frequency of 2.45 GHz. An embodiment usable in this case may be such that non-polymerizable gas is introduced together with hydrocarbon gas and that plasma modification is simultaneously performed.

When plasma treatment with non-polymerizable gas is performed prior to plasma treatment with hydrocarbon gas, for example, the pressure in the system is reduced, non-polymerizable gas is then introduced to make the pressure in the vacuum chamber to 10 to 500 Pa, preferably 20 to 100 Pa, and electric power of about 10 to 30,000 W is supplied for 1 to 30 minutes using a high-frequency power source with a frequency of, for example, 40 kHz or 13.56 MHz. Subsequently, plasma treatment is performed using hydrocarbon gas or a gas mixture of hydrocarbon gas and non-polymerizable gas for forming an amorphous carbon film. For example, when argon gas is used as the non-polymerizable gas, the surface structure of polytetrafluoroethylene is modified, and surface etching is performed.

Application of the plasma CVD method only to the surfaces of the abutting part having various shapes is performed in a state where the seal ring opens so that the plasma CVD method is applied only to at least one of the facing surfaces in the abutting part of the seal ring.

When the plasma CVD method is applied to only one surface of the abutting part of the seal ring, it is necessary to previously cover the other surface with a film, etc. In order to avoid such a complicated process, it is desirable that the plasma CVD method is applied to both facing surfaces of the abutting part.

### EXAMPLES

The following describes the present invention with reference to Examples.

### Example 1

PTFE (G163, produced by Asahi Glass Co. Ltd.; 68 wt.%), 30 wt.% of glass fiber (CSX-3J-451S, produced by Nitto Boseki Co. Ltd.), and 2 wt.% of oil coke (produced by Chuetsu Graphite Works Co. Ltd.; average particle diameter: 20 µm) were mixed using a mixer, and then compression-molded by a compression molding machine at 10 to 20 MPa. The obtained molded products were then sintered in a baking oven at a temperature equal to or higher than the melting point, thereby producing cubic test pieces (4 x 4 x 4 mm).

The obtained test pieces were allowed to stand on a lower electrode in a vacuum chamber of a low-pressure plasma device, and the inside of the vacuum chamber was evacuated until the degree of vacuum in the vacuum chamber reached 10 Pa by a vacuum pump. Argon gas was introduced when this vacuum degree is achieved. While the pressure in the vacuum chamber was maintained at about 60 Pa, electric power of 200 W was supplied to an upper electrode for 10 minutes from a high-frequency power supply with a frequency of 13.56 MHz to convert the argon gas into plasma, and the PTFE surface was treated by plasma modification.

Thereafter, acetylene gas was supplied for 5 minutes in place of argon gas. While maintaining the pressure in the vacuum chamber at about 30 Pa, electric power of 200 W was supplied to the upper electrode for 10 minutes from the high-frequency power source with a frequency of 13.56 MHz to convert the acetylene gas into plasma, and an amorphous carbon film was formed on the PTFE surface (plasma CVD treatment). In the low-pressure plasma device used herein, the upper electrode and the lower electrode were arranged so as to face each other in the upper and lower sides, respectively, in the vacuum chamber equipped with a gas supply section and a gas discharge unit on the external side of the device. The upper electrode was connected to the high-frequency power supply disposed in the outside of the vacuum chamber, and an earth wire was provided from the lower electrode to the outside of the vacuum chamber.

The following two sticking resistance evaluations were performed using the test pieces each having an amorphous carbon film formed thereon.

Sticking resistance evaluation A: The PTFE surface (4 x 4 mm) of a test piece having an amorphous carbon film formed thereon, and the untreated PTFE surface (4 x 4 mm) of a test piece were superposed and held by a jig. Then, while applying load at a surface pressure of 3 MPa under room temperature conditions, slight vibration was applied at a frequency of 200 Hz for 30 seconds. After removing the jig, the test pieces were pulled vertically to their bonding surfaces, and sticking strength was measured by an autograph.

Sticking resistance evaluation B: Both end parts of each of the PTFE surface of a test piece having an amorphous carbon film formed thereon, and the untreated PTFE surface of a test piece were superposed at the above length, and held by a jig. Then, while applying load at a surface pressure of 7 MPa, the test piece was maintained at 160°C for 1 hour. After cooling, the jig was removed, the test pieces were pulled vertically to their bonding surfaces, and sticking strength was measured by an autograph.

### Example 2

In Example 1, the two sticking resistance evaluations were conducted using test pieces where their PTFE surfaces having an amorphous carbon film formed thereon were superposed and held by a jig.

### Example 3

In Example 1, the two sticking resistance evaluations were conducted on test pieces on which amorphous carbon films were formed while the time of plasma CVD treatment using acetylene gas was changed to 20 minutes.

### Example 4

In Example 3, the two sticking resistance evaluations were conducted using test pieces where their PTFE surfaces having an amorphous carbon film formed thereon were superposed and held by a jig.

### Example 5

In Example 1, the two sticking resistance evaluations were conducted on test pieces on which amorphous carbon films were formed while the time of plasma CVD treatment using acetylene gas was changed to 30 minutes.

### Example 6

In Example 5, the two sticking resistance evaluations were conducted using test pieces where their PTFE surfaces having an amorphous carbon film formed thereon were superposed and held by a jig.

### Example 7

In Example 1, the two sticking resistance evaluations were conducted on test pieces on which amorphous carbon films were formed by performing plasma modification using argon gas, and then supplying acetylene gas simultaneously with the same amount of argon gas.

### Example 8

In Example 7, the two sticking resistance evaluations were conducted using test pieces where their PTFE surfaces having an amorphous carbon film formed thereon were superposed and held by a jig.

### Example 9

In Example 7, the two sticking resistance evaluations were conducted on test pieces on which amorphous carbon films were formed while the time of plasma CVD treatment using a gas mixture of acetylene and argon was changed to 20 minutes.

### Example 10

In Example 9, the two sticking resistance evaluations were conducted using test pieces where their PTFE surfaces having an amorphous carbon film formed thereon were superposed and held by a jig.

### Example 11

In Example 7, the two sticking resistance evaluations were conducted on test pieces on which amorphous carbon films were formed while the time of plasma CVD treatment using a gas mixture of acetylene and argon was changed to 30 minutes.

### Example 12

In Example 11, the two sticking resistance evaluations were conducted using test pieces where their PTFE surfaces having an amorphous carbon film formed thereon were superposed and held by a jig.

### Example 13

In Example 1, the two sticking resistance evaluations were conducted on test pieces on which amorphous carbon films were formed while plasma modification using argon gas was not performed, and the time of plasma CVD treatment using acetylene gas was changed to 10 minutes.

### Example 14

In Example 13, the two sticking resistance evaluations were conducted using test pieces where their PTFE surfaces having an amorphous carbon film formed thereon were superposed and held by a jig.

### Example 15

In Example 13, the two sticking resistance evaluations were conducted on test pieces on which amorphous carbon films were formed by supplying acetylene gas simultaneously with the same amount of argon gas.

### Example 16

In Example 15, the two sticking resistance evaluations were conducted using test pieces where their PTFE surfaces having an amorphous carbon film formed thereon were superposed and held by a jig.

### Example 17

In Example 13, the two sticking resistance evaluations were conducted on test pieces on which amorphous carbon films were formed using methane gas in place of acetylene gas.

### Example 18

In Example 17, the two sticking resistance evaluations were conducted using test pieces where their PTFE surfaces having an amorphous carbon film formed thereon were superposed and held by a jig.

### Example 19

In Example 13, the two sticking resistance evaluations were conducted on test pieces on which amorphous carbon films were formed using an equivalent volume gas mixture of methane and argon in place of acetylene gas.

### Example 20

In Example 19, the two sticking resistance evaluations were conducted using test pieces where their PTFE surfaces having an amorphous carbon film formed thereon were superposed and held by a jig.

### Comparative Example 1

In Example 1, the two sticking resistance evaluations were conducted on test pieces where their untreated PTFE surfaces were superposed and held by a jig.

Table 1 below shows the results obtained in Examples 1 to 20 and Comparative Example 1.

**Table 1**

| | Example | | | | | | | | | Comp. Ex. |
|---|---|---|---|---|---|---|---|---|---|---|
| Sticking resistance evaluation | 1-12 | 13 | 14 | 15 | 16 | 17 | 18 | 19 | 20 | 1 |
| A (MPa) | 0.00 | 0.00 | 0.00 | 0.00 | 0.00 | 0.00 | 0.00 | 0.00 | 0.00 | 0.10 |
| B (MPa) | 0.00 | 0.02 | 0.00 | 0.05 | 0.04 | 0.12 | 0.12 | 0.01 | 0.09 | 0.65 |

### Examples 21 to 40 and Comparative Example 2

In Examples 1 to 20 and Comparative Example 1, the amount of PTFE was changed to 70 wt.%, the amount of oil coke was changed to 30 wt.%, and glass fiber was not used. Table 2 below shows the obtained results.

**Table 2**

| | Example | | | | | | | | | | | Comp. Ex. |
|---|---|---|---|---|---|---|---|---|---|---|---|---|
| Sticking resistance evaluation | 21-26 | 27 | 28-32 | 33 | 34 | 35 | 36 | 37 | 38 | 39 | 40 | 2 |
| A (MPa) | 0.00 | 0.00 | 0.00 | 0.00 | 0.00 | 0.00 | 0.00 | 0.00 | 0.00 | 0.00 | 0.00 | 0.05 |
| B (MPa) | 0.00 | 0.02 | 0.00 | 0.01 | 0.00 | 0.01 | 0.00 | 0.03 | 0.01 | 0.06 | 0.04 | 0.23 |

### Examples 41 to 60 and Comparative Example 3

In Examples 1 to 20 and Comparative Example 1, the amount of PTFE was changed to 67 wt.%, the amount of oil coke was changed to 3 wt.%, and the same amount (30 wt.%) of carbon black (Ketchen Black ECP600JD, produced by Mitsubishi Chemical Corporation) was used in place of glass fiber. Table 3 below shows the obtained results.

**Table 3**

| | Example | | | | | | | | | Comp. Ex. |
|---|---|---|---|---|---|---|---|---|---|---|
| Sticking resistance evaluation | 41-52 | 53 | 54 | 55 | 56 | 57 | 58 | 59 | 60 | 3 |
| A (MPa) | 0.00 | 0.00 | 0.00 | 0.00 | 0.00 | 0.00 | 0.00 | 0.00 | 0.00 | 0.02 |
| B (MPa) | 0.00 | 0.02 | 0.00 | 0.00 | 0.00 | 0.01 | 0.00 | 0.00 | 0.01 | 0.23 |

## Claims

1. A PTFE resin seal ring in which an amorphous carbon film is formed on at least one surface of an abutting part that forms a discontinuous part of the seal ring.

2. The PTFE resin seal ring according to claim 1, wherein the amorphous carbon film is formed by plasma CVD treatment using hydrocarbon gas.

3. The PTFE resin seal ring according to claim 2, wherein the hydrocarbon gas is methane, ethylene, propylene, or acetylene.

4. The PTFE resin seal ring according to claim 2 or 3, wherein the plasma CVD treatment is performed using non-polymerizable gas in combination with hydrocarbon gas.

5. The PTFE resin seal ring according to claim 2 or 3, wherein after at least one surface of the abutting part is treated by plasma modification using non-polymerizable gas, the modified surface is subjected to plasma CVD treatment using hydrocarbon gas or a gas mixture of hydrocarbon gas and non-polymerizable gas.

6. The PTFE resin seal ring according to claim 1, wherein the PTFE resin is a filler-containing PTFE resin.

7. The PTFE resin seal ring according to claim 6, wherein the filler-containing PTFE resin is a PTFE resin containing glass fiber, carbon fiber, ceramic fiber, ceramic powder, graphite powder, coke powder, carbon beads, carbon black, or bronze powder.

## Patentansprüche

1. PTFE-Harz-Dichtungsring, in welchem ein amorpher Kohlenstofffilm auf wenigstens einer Oberfläche eines angrenzenden Teils, der einen diskontinuierlichen Teil des Dichtungsrings bildet, ausgebildet ist.

2. PTFE-Harz-Dichtungsring gemäß Anspruch 1, wobei der amorphe Kohlenstofffilm durch Plasma-CVD-Behandlung unter Verwendung von Kohlenwasserstoffgas gebildet ist.

3. PTFE-Harz-Dichtungsring gemäß Anspruch 2, wobei das Kohlenwasserstoffgas Methan, Ethylen, Propylen oder Acetylen ist.

4. PTFE-Harz-Dichtungsring gemäß Anspruch 2 oder 3, wobei die Plasma-CVD-Behandlung unter Verwendung eines nichtpolymerisierbaren Gases in Kombination mit Kohlenwasserstoffgas durchgeführt wird.

5. PTFE-Harz-Dichtungsring gemäß Anspruch 2 oder 3, wobei, nachdem wenigstens eine Oberfläche des angrenzenden Teils durch Plasmamodifizierung unter Verwendung von nichtpolymerisierbarem Gas behandelt worden ist, die modifizierte Oberfläche einer Plasma-CVD-Behandlung unter Verwendung von Kohlenwasserstoffgas oder einem Gasgemisch aus Kohlenwasserstoffgas und nicht-polymerisierbarem Gas unterzogen wird.

6. PTFE-Harz-Dichtungsring gemäß Anspruch 1, wobei das PTFE-Harz ein Füllstoff enthaltendes PTFE-Harz ist.

7. PTFE-Harz-Dichtungsring gemäß Anspruch 6, wobei das Füllstoff enthaltende PTFE-Harz ein PTFE-Harz ist, das Glasfaser, Kohlenstofffaser, Keramikfaser, Keramikpulver, Graphitpulver, Kokspulver, Kohlenstoffperlen, Ruß oder Bronzepulver enthält.

## Revendications

1. Bague d'étanchéité en résine PTFE, dans laquelle un film de carbone amorphe est formé sur au moins une surface d'une partie aboutante qui forme une partie discontinue de la bague d'étanchéité.

2. Bague d'étanchéité en résine PTFE selon la revendication 1, dans laquelle le film de carbone amorphe est formé par un traitement de dépôt chimique en phase vapeur (CVD) assisté par plasma en utilisant un hydrocarbure gazeux.

3. Bague d'étanchéité en résine PTFE selon la revendication 2, dans laquelle l'hydrocarbure gazeux est le méthane, l'éthylène, le propylène ou l'acétylène.

4. Bague d'étanchéité en résine PTFE selon la revendication 2 ou 3, dans laquelle le traitement CVD assisté par plasma est exécuté en utilisant un gaz non polymérisable en combinaison avec un hydrocarbure gazeux.

5. Bague d'étanchéité en résine PTFE selon la revendication 2 ou 3, dans lequel, après avoir traité au moins une surface de la partie aboutante par modification au plasma en utilisant un gaz non polymérisable, la surface modifiée est soumise à un traitement CVD assisté par plasma en utilisant un hydrocarbure gazeux ou un mélange gazeux d'hydrocarbure gazeux et de gaz non polymérisable.

6. Bague d'étanchéité en résine PTFE selon la revendication 1, dans laquelle la résine PTFE est une résine PTFE contenant une charge.

7. Bague d'étanchéité en résine PTFE selon la revendication 6, dans laquelle la résine PTFE contenant une charge est une résine PTFE contenant de la fibre de verre, de la fibre de carbone, de la fibre de céramique, de la poudre de céramique, de la poudre de graphite, de la poudre de coke, des billes de carbone, du noir de carbone ou de la poudre de bronze.
